# EUROPEAN PATENT APPLICATION

(11) **EP 2 008 967 A2**
(43) Date of publication of application: **31.12.2008**
(21) Application number: 08158888.1
(22) Date of filing: 24.06.2008
(51) Int. Cl.: B81C 1/00

(54) **Thick active layer for MEMS device using wafer dissolve process**

(30) Priority: 27.06.2007 US 769543
(71) Applicant: Honeywell International Inc., Morristown NJ 07960 (US)
(72) Inventor: Yu, Lianzhong, Redmond, WA 98053 (US); Zhou, Shifang, Redmond, WA 98052 (US)
(74) Representative: Buckley, Guy Julian

(57) **Abstract**

Methods for producing MEMS (microelectromechanical systems) devices with a thick active layer and devices produced by the method. An example method includes heavily doping a first surface of a first silicon wafer with P-type impurities (12), and heavily doping a first surface of a second silicon wafer with N-type impurities (14). The heavily doped first surfaces are then bonded together (16), and a second side of the first wafer opposing the first side of the first wafer is thinned (18) to a desired thickness, which may be greater than about 30 micrometers. The second side is then patterned and etched (20), and the etched surface is then heavily doped with P-type impurities (22). A cover is then bonded to the second side of the first wafer (24), and the second wafer is thinned (26).

## Description

### BACKGROUND OF THE INVENTION

Microelectromechanical systems (MEMS) devices, such as accelerometers and gyroscopes, are fabricated in many different ways. One common way is the wafer dissolve process, because of its simplicity and the maturity of the process. However, in order to get the higher doping required by the wafer dissolve process, a highly doped epitaxy layer is used for the starting material, which is limited to less than 30 micrometers thick.

### SUMMARY OF THE INVENTION

The present invention provides methods for fabricating MEMS active layers of any thickness using a wafer bonding and wafer dissolve process, and devices fabricated by those methods.

One embodiment of a method according to the present invention includes heavily doping a first surface of a first silicon wafer with P-type impurities, and heavily doping a first surface of a second silicon wafer with N-type impurities. The heavily doped first surfaces are then bonded together, and a second side of the first wafer opposing the first side of the first P-type wafer is thinned to a desired thickness, which may be greater than about 30 micrometers. The second side is then patterned and etched, and the etched surface is then heavily doped with P-type impurities. A cover is then bonded to the second side of the first P-type wafer, and the second N-type wafer is thinned.

### BRIEF DESCRIPTION OF THE DRAWINGS

Preferred and alternative embodiments of the present invention are described in detail below with reference to the following drawings:

FIGURE 1 is a flow diagram of an embodiment of the present invention;

FIGURES 2A-2G are illustrations of various intermediate structures formed during the method of FIGURE 1;

FIGURE 3 is a flow diagram of an alternate embodiment of the present invention; and

FIGURES 4A-4E are illustrations of various intermediate structure formed during the method of FIGURE 3.

### DETAILED DESCRIPTION OF THE PREFERRED EMBODIMENT

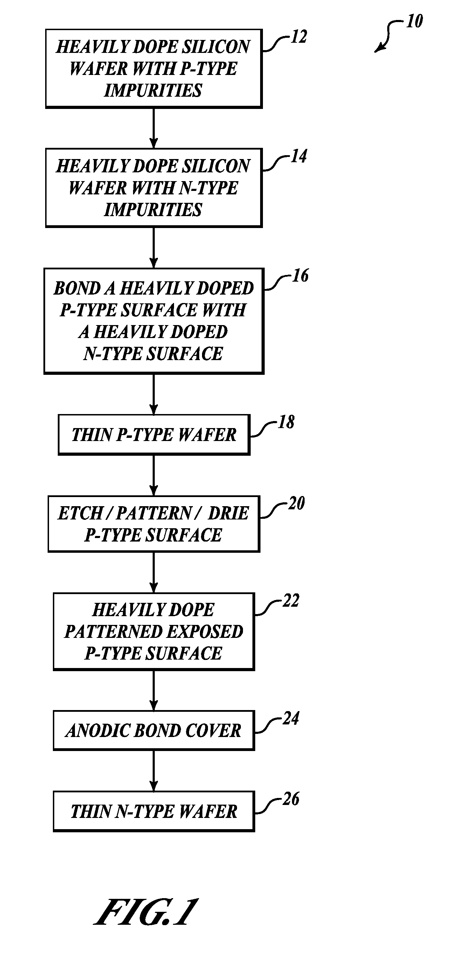

FIGURE 1 is a flow diagram of one embodiment of a method 10 according to the present invention. At a block 12, at least one surface of a first silicon wafer is heavily doped with P-type impurities to a level greater than about 5 X 10E19/cm³, using furnace diffusion. At a block 14, at least one surface of a second silicon wafer is heavily doped with N-type impurities to a level of greater than about 5 X 10E19/cm³, using furnace diffusion. At a block 16, the heavily doped surface of the first wafer is bonded to the heavily doped surface of the second wafer using silicon fusion bonding. At a block 18, the P-type wafer is thinned to a desired thickness using lapping or chemical polishing. At a block 20, the P-type wafer is patterned and etched using Deep Reactive Ion Etching (DRIE) to form various MEMS devices (not shown) depending on the intended use of the device. At a block 22, the etched surface is heavily doped with P-type impurities to a level of about 5 X 10E19/cm³, using furnace diffusion. At a block 24, a cover is bonded to the P-type wafer such that it covers and protects the patterned surface; in the case where the cover is Pyrex^{®} glass, the cover is anodically bonded. Finally, at a block 26, EDP (ethylenediamine pyrocatechol) is used to thin the N-type wafer; KOH etching can also be used. The P-type wafer is protected during the step of block 26 because the heavily doped P-type layer shields the P-type layer from EDP etching.

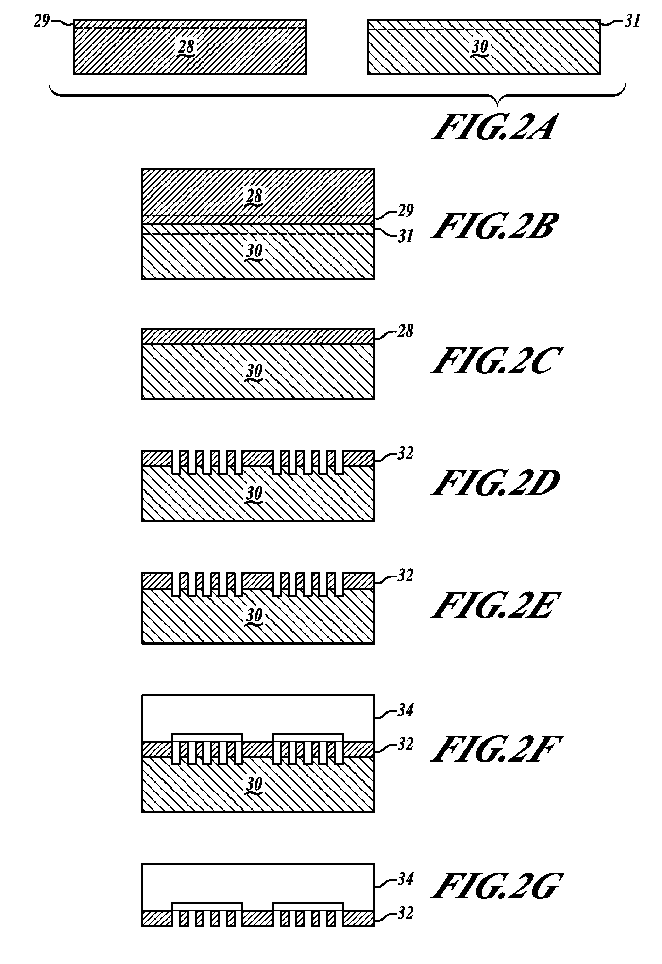

FIGURES 2A-2G illustrate various intermediate steps and structures performed and created during the method 10 shown in FIGURE 1. FIGURE 2A shows a first silicon wafer (or P-type wafer) 28 with an area 29 that has been heavily doped with P-type impurities, and a second silicon wafer (or N-type wafer) 30 with an area 31 that has been heavily doped with N-type impurities to a depth of about 5 to 10 micrometers. FIGURE 2B shows the wafers 28, 30 after bonding the areas 29, 31 to each other. FIGURE 2C shows the wafers 28, 30 after thinning the P-type wafer to a desired thickness of about 50 to 200 micrometers, and even thicker if desired. FIGURE 2D shows the wafers 28, 30 after patterning and etching the P-type wafer with DRIE to form an active layer 32; that is, wafer 28 is patterned and etched to form active layer 32. FIGURE 2E shows the wafer 30 and active layer 32 after the active layer 32 has been heavily doped with P-type impurities. FIGURE 2F shows the N-type wafer 30, the active layer 32, and a cover 34 bonded to the active layer 32. Finally, FIGURE 2G shows the active layer 32 and cover 34 after thinning the N-type wafer 30.

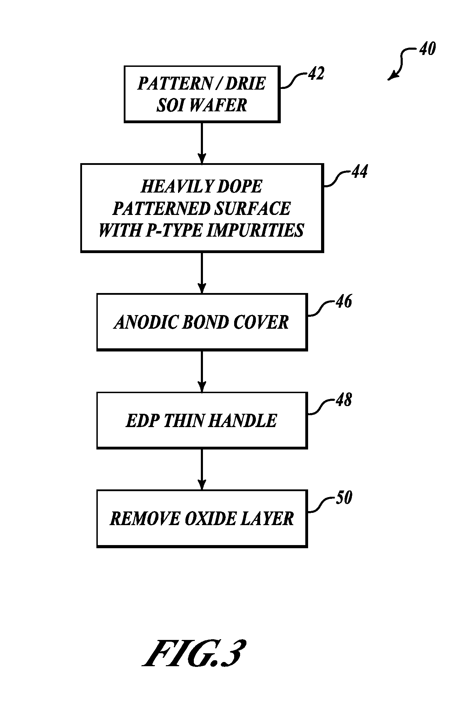

FIGURE 3 is a flow diagram of an alternate embodiment of a method 40 of the present invention. At a block 42, a silicon-on-insulator (SOI) wafer, including an active layer, an oxide layer, and a handle layer, is patterned and etched using DRIE. At a block 44, the etched surface is heavily doped with P-type impurities. At a block 46, a cover is anodically bonded to the active layer. At a block 48, EDP is used to thin the handle layer; alternately, silicon chemical etching may be used; KOH or TMAH can also be used. Finally, at a block 50, the oxide layer is removed.

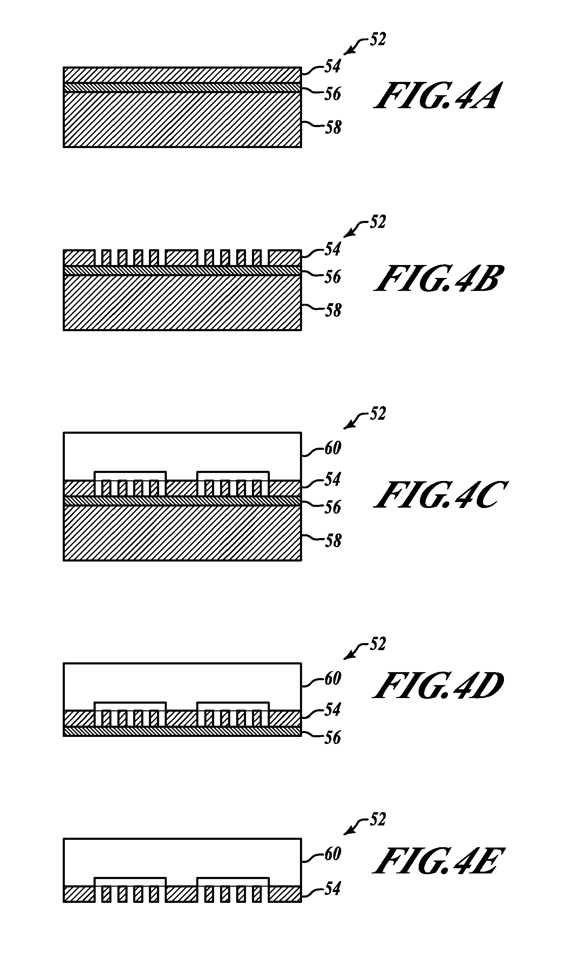

FIGURES 4A-4E illustrate various intermediate steps and structures of the method 40 shown in FIGURE 3. FIGURE 4A shows a SOI wafer 52, including an active layer 54, an oxide layer 56, and a handle layer 58. FIGURE 4B shows the wafer 52 after patterning the active layer 54. FIGURE 4C shows the wafer 52 after heavy doping and bonding a cover 60 to the active layer 54. FIGURE 4D shows the wafer 52 after thinning the handle layer 58. Finally, FIGURE 4E shows the wafer 52 after removing the oxide layer 56.
The embodiments of the invention in which an exclusive property or privilege is claimed are defined as follows:

## Claims

1. A method comprising:
bonding a heavily doped P-type surface of a first wafer to a heavily doped N-type surface of a second wafer (16);
thinning the first wafer to a desired thickness (18);
patterning the first wafer (20);
heavily doping the patterned first wafer with P-type impurities (22);
bonding a cover to the first wafer (24); and
thinning the second wafer (26).

2. The method of Claim 1, further comprising:
heavily doping a surface of the first wafer with P-type impurities (12); and
heavily doping a surface of the second wafer with N-type impurities (14).

3. The method of Claim 1, wherein bonding the first wafer to the second wafer comprises:
bonding by silicon fusion bonding.

4. The method of Claim 1, wherein thinning the first wafer comprises:
thinning using one of lapping and chemical polishing.

5. The method of Claim 1, wherein patterning coomprises:
patterning using Deep Reactive Ion Etching (DRIE).

6. The method of Claim 1, wherein bonding a cover comprsies:
anodically bonding the cover.

7. The method of Claim 1, wherein thinning comprsies:
thinning with ethylenediamene pyrocatecol (EDP).

8. The method of Claim 1, wherein thinning the second wafer comprises:
removing the second wafer.

9. A device comprising:
a first wafer (28) including a first and a second opposing side, the first side heavily doped with P-type impurities, the second side patterned and heavily-doped with P-type impurities;
a second wafer (30) with a first side, the first side of the second wafer heavily doped with N-type impurities and bonded to the first side of the first wafer.

10. The device of Claim 9, further comprising:
a patterned active layer with a thickness greater than about 30 micrometers, wherein the patterned active layer is heavily doped with P-type impurities.
